Europäisches Patentamt

European Patent Office

Office européen des brevets

(19)

(11) **EP 0 887 804 B1**

(12) **FASCICULE DE BREVET EUROPEEN**

(45) Date de publication et mention
de la délivrance du brevet:
**06.09.2000 Bulletin 2000/36**

(51) Int Cl.⁷: $G11C\ 11/409$, G11C 7/06

(21) Numéro de dépôt: **98470013.8**

(22) Date de dépôt: **03.06.1998**

(54) **Procédé et circuit de lecture pour mémoire dynamique**

Leseverfahren und Schaltung für dynamischen Speicher

Read method and circuit for dynamic memory

(84) Etats contractants désignés:
**DE FR GB IT**

(30) Priorité: **19.06.1997 FR 9707809**

(43) Date de publication de la demande:
**30.12.1998 Bulletin 1998/53**

(73) Titulaire: **STMicroelectronics S.A.**
**94250 Gentilly (FR)**

(72) Inventeur: **Ferrant, Richard**
**57000 Metz (FR)**

(74) Mandataire: **Ballot, Paul Denis Jacques**
**Cabinet Ballot-Schmit,**
**9 Rue Claude Chappé**
**57070 Metz (FR)**

(56) Documents cités:
**US-A- 4 634 901**      **US-A- 5 319 589**
**US-A- 5 323 349**      **US-A- 5 353 255**
**US-A- 5 406 148**

**Description**

L'invention concerne les mémoires en circuit intégré et, plus particulièrement, les procédés et circuits de lecture permettant de détecter des états logiques mémorisés dans des cellules de mémoires dynamiques à accès aléatoire, plus connues sous l'acronyme DRAM.

Les mémoires sont, classiquement, organisées en matrices de cellules de mémorisation. Les cellules d'une même colonne sont reliées à une ou des lignes de bit, et sont accessibles individuellement par le biais de lignes de mot.

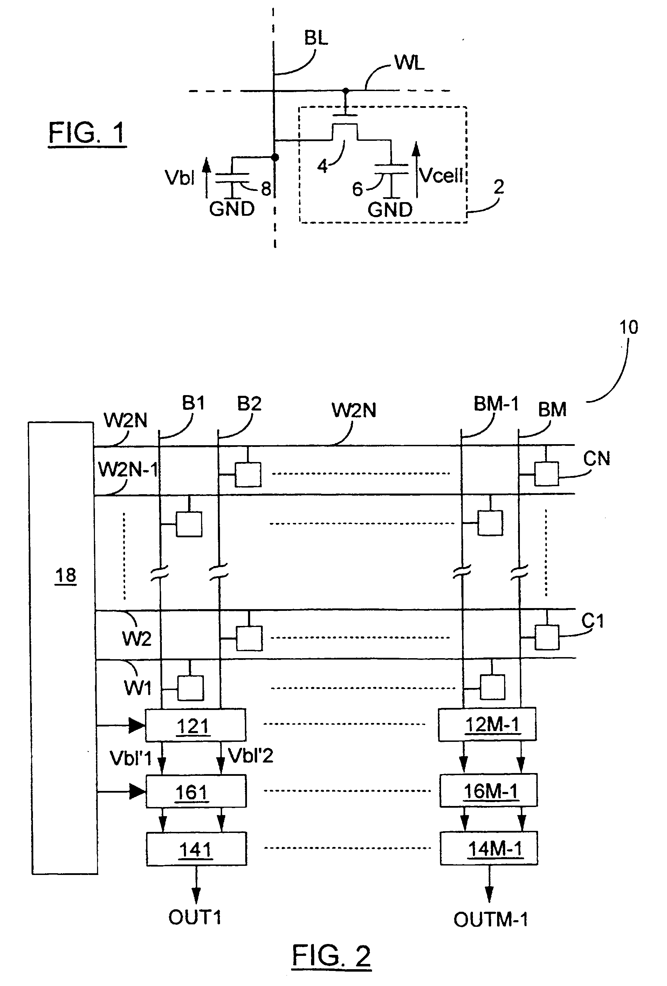

La figure 1 illustre, schématiquement, une cellule de mémorisation 2 typique de mémoire DRAM. Cette cellule 2 comprend un transistor de sélection 4 et un condensateur de mémorisation 6.

Dans l'exemple illustré, le transistor de sélection 4 est un transistor de type MOS, à canal N. Sa grille de commande est reliée à une ligne de mot WL et son drain est relié à une ligne de bit BL. Sa source est reliée à un premier pôle du condensateur 6. Ce condensateur a un deuxième pôle qui reçoit un potentiel de référence GND, encore appelé potentiel de masse. La cellule de mémorisation permet de mémoriser une information logique définie en fonction de la tension Vc présente aux bornes du condensateur 6, c'est-à-dire, en pratique, en fonction du potentiel Vc (en considérant que GND = 0 V) de son premier pôle. On peut généralement stocker deux états logiques, un état haut et un état bas, selon que le condensateur est chargé ou non. Dans le premier cas, la tension Vc est par exemple égale à VCC avec VCC un potentiel d'alimentation positif de la DRAM. Dans le second cas, on aura Vc = GND.

Supposons que le potentiel de la ligne de mot WL soit inférieur ou égal au potentiel de la ligne de bit BL. Le transistor de sélection 4 est alors bloqué et le condensateur 6 est isolé de la ligne de bit. Pour lire l'information stockée dans la cellule 2, on impose, par le biais d'un dispositif de précharge, un potentiel de référence Vref sur la ligne de bit. Généralement, le potentiel Vref est choisi de telle sorte qu'il soit intermédiaire entre les valeurs VCC et GND pouvant être pris par le potentiel Vc. Typiquement, on choisira Vref = VCC/2. La ligne de bit BL présente une certaine capacité équivalente Cbl (représentée sur la figure 1 par un condensateur parasite 8) et mémorise le potentiel Vref par effet capacitif. Puis, on sélectionne la cellule 2, c'est-à-dire qu'on rend passant le transistor 4 en appliquant un potentiel de commande adéquat sur la ligne de mot WL. En pratique, cette sélection sera réalisée en portant la ligne de mot au potentiel VCC.

On assiste alors à un transfert de charges entre le condensateur de mémorisation 6 et le condensateur parasite 8, tendant à rendre égales les tensions aux bornes de ces deux condensateurs. Le sens et l'importance de ce transfert de charges sont fonctions des valeurs respectives des condensateurs 6 et 8, et des tensions à leurs bornes.

En notant Ccell la capacité du condensateur 6 et Vc1 la tension initiale à ses bornes, on obtient ainsi à ses bornes, après transfert de charges, une tension Vc2 définie par la relation suivante (en considérant, pour simplifier, que le transistor de sélection n'introduit pas de chute de tension):

$$Vc2 = (Cb1 * Vref + Ccell * Vc1) / (Cb1 + Ccell).$$

Si on suppose que l'on a Vref= VCC / 2 et Vc1 = GND = 0, alors on obtient :

$$Vc2 = Vc2(0) = (VCC/2) * [Ccell / (Cb1 + Ccell)]$$

Si on suppose que Vc1 = VCC, on obtient :

$$Vc2 = Vc2(1) = (VCC/2) * [(Cb1 + 2 * Ccell) / (Cb1 + Ccell)]$$

Dans le premier cas, le transfert de charges s'effectue de la ligne de bit BL vers la cellule de mémorisation 2.

Dans le second cas, le transfert de charges s'effectue de la cellule de mémorisation 2 vers la ligne de bit BL.

Il suffit d'utiliser un comparateur recevant Vc2 et Vref = VCC/2 (ce potentiel VCC/2 étant par exemple présent sur une ligne de bit utilisée comme référence) pour obtenir un signal logique de lecture dont l'état est représentatif de l'information mémorisée initialement dans la cellule 2.

En notant $\Delta V(0) = (VCC/2) - Vc2(0)$ et $\Delta V(1) = Vc2(1) - (VCC/2)$, on a $\Delta V(0) = \Delta V(1) = \Delta V = Ccell * (VCC/2) / (Ccell + Cb1)$.

La tension aux bornes du condensateur de la cellule de mémorisation étant modifiée lorsque l'on la lit, la lecture d'une cellule comprend une dernière étape, dite de rafraîchissement, pour rétablir la tension initiale aux bornes du condensateur de mémorisation. Si ce n'était pas le cas, la différence entre les valeurs du potentiel Vc représentatives des états logiques aurait tendance à diminuer, jusqu'à rendre incertain le résultat de la lecture.

Les mémoires DRAM sont généralement associées à des processeurs et utilisées comme mémoires tampons. Une caractéristique essentielle de ces mémoires est donc leur rapidité. La lecture sera d'autant plus rapide que la valeur du condensateur de mémorisation 6 sera faible. Typiquement, on utilise des condensateurs de l'ordre de grandeur du dixième de picofarad. Cet ordre de grandeur pose un problème dans la mesure où la variation de potentiel aux bornes de ce condensateur, par transfert de charges, est d'autant plus faible que la valeur du condensateur de mémorisation est faible. Pour obtenir un signal de lecture néanmoins interprétable, et éviter des erreurs de lecture, on doit garantir une différence de potentiel minimale entre Vc2 et le potentiel de référence VCC/2. On cherchera, par exemple, à garantir Vc2(0) < 0.9 * VCC/2 et Vc2(1) > 1.1 * VCC/2, ce qui représente une marge minimale de variation du potentiel Vc2 de plus ou moins 10 % par rapport au signal de référence. Cela représente, pour VCC = 3 volts, une différence de potentiel ΔV de 150 millivolts sur les entrées du comparateur produisant le signal de lecture, limite en deçà de laquelle il est difficile, en pratique, de descendre. Il est par ailleurs préférable de ne pas avoir une marge trop importante car plus cette marge est importante, moins la lecture est rapide. En effet, la durée nécessaire au transfert de charges entre la ligne de bit et la cellule de mémorisation est d'autant moins grande que la marge prévue est faible. Si on considère que le potentiel VCC est fixe, une marge de plus ou moins 10 % suppose, en pratique, d'avoir Cb1 = 10 * Ccell, c'est-à-dire de l'ordre du picofarad.

Un problème posé par les mémoires DRAM est, en pratique, de réaliser une mémoire qui soit à la fois rapide et qui assure une marge de lecture suffisante. Plus la capacité Cb1 est importante, moins la variation de ΔV en fonction de l'état stocké est importante.

Une solution est d'augmenter la valeur de Ccell, ce qui permet d'augmenter ΔV. Mais on pénalise alors la mémoire en terme de rapidité. D'autre part, pour une technologie donnée, cela nécessite d'utiliser des condensateurs plus volumineux, ce qui est pénalisant en terme d'intégration. Un transfert vers une technologie de définition minimale plus petite nécessitera, en outre, une redéfinition des condensateurs de mémorisation. A défaut, la simple transposition d'une structure de condensateur se traduirait, en effet, par une diminution de la valeur des condensateurs et par une marge de lecture diminuée.

Une autre solution est de limiter la valeur de Cb1. Pour ce faire, on peut limiter la longueur des lignes de bit et, par suite, le nombre de cellules accessibles par ligne de bit. Il est alors nécessaire, si on souhaite obtenir une capacité de mémoire importante, de multiplier le nombre de lignes de bits. Or, on cherche généralement à limiter la surface occupée par les circuits pour en minimiser les coûts et la consommation.

Une autre solution pour augmenter la valeur de ΔV est d'augmenter la valeur du potentiel d'alimentation VCC. Un problème se pose alors quand on cherche à réaliser des circuits aptes à fonctionner à basse tension, par exemple avec VCC = 3 volts, voire moins. La diminution de VCC entraîne en effet une diminution de la marge de lecture.

En supposant que l'on puisse trouver une solution permettant de concilier rapidité et marge de lecture suffisante, un autre problème se pose si on souhaite augmenter l'intégration des circuits en utilisant une technologie de définition minimale plus petite.

En effet, les tensions de seuil des transistors, et les tensions d'offset qui en découlent, ont alors tendance à augmenter. Comme on l'a vu précédemment, il est difficile d'allier la rapidité de la mémoire avec une marge de lecture suffisante. On risque, si on change de technologie, d'avoir à modifier le comparateur de lecture, la marge de lecture devenant trop faible par rapport aux capacités du comparateur. Ce problème est également renforcé, comme on l'a vu, par le fait qu'une simple transposition se traduit par une diminution de la valeur de Ccell, ce qui pénalise la marge de lecture, à valeur de Cbl équivalente.

Un but de l'invention est de proposer un dispositif et un procédé de lecture de mémoire améliorés qui permettent d'utiliser des condensateurs de mémorisation de valeur plus faible, ce qui permet d'améliorer la rapidité, tout en garantissant une marge de lecture suffisante. On peut alors augmenter l'intégration des mémoires et minimiser les problèmes liés au transfert de fabrication vers une technologie de définition minimale inférieure.

Un autre but de l'invention est de proposer un dispositif et un procédé de lecture qui permettent d'augmenter la valeur de la capacité équivalente des lignes de bit tout en garantissant une marge de lecture suffisante, ce qui permet de rendre possible une plus grande intégration.

Un autre but de l'invention est de proposer un dispositif et un procédé de lecture qui permettent de réaliser une mémoire qui soit apte à fonctionner à faible tension d'alimentation tout en garantissant une marge de lecture suffisante.

Un autre but de l'invention est de proposer un dispositif et un procédé de lecture qui permettent de minimiser les problèmes d'augmentation de tension d'offset et de diminution de marge de lecture lorsque l'on souhaite transférer la production dans une technologie à définition minimale plus faible.

L'invention propose de remplacer la lecture classique des cellules, par mesure de variations de potentiel à l'aide d'un comparateur, par une lecture comprenant une opération de décharge des lignes de bit et de référence. La variation des potentiels entre les lignes de bit et de référence n'est plus utilisée directement, mais pour moduler les valeurs des courants de décharge de ces lignes. A partir de décharges différenciées, on peut amplifier la différence de potentiel créée initialement entre les lignes de bit et de référence, lorsque la cellule lue est reliée à la ligne de bit, ce qui permet d'accélérer la lecture. L'invention permet, de ce fait, de minimiser l'influence des valeurs des condensateurs de mémorisation et des capacités des lignes de bit. On peut, dès lors, envisager d'augmenter la taille des lignes de bit, ce qui permet d'obtenir une densité d'intégration plus importante. On peut également réaliser plus facilement des circuits fonctionnant à basse tension d'alimentation. D'autre part, on minimise l'influence des tensions d'offset qui pénalise la lecture en tension. Il est alors plus facile de changer de technologie en diminuant la définition minimale.

Ainsi, l'invention concerne un procédé de lecture d'une mémoire dynamique comprenant au moins une ligne de bit, une ligne de mot, une cellule de mémorisation accessible par le biais de la ligne de bit et de la ligne de mot, et une ligne de référence, la cellule de mémorisation permettant de mémoriser un potentiel initial représentatif d'une information logique. Le procédé comprend une étape de précharge de la ligne de bit et de la ligne de référence, pour porter le potentiel de ces lignes au niveau d'un potentiel de référence différent du potentiel initial mémorisé dans la cellule de mémorisation, une étape de sélection de la cellule de mémorisation, pour produire une modification du potentiel de la ligne de bit et créer ainsi une différence initiale entre les potentiels de la ligne de bit et de la ligne de référence, une étape de décharge de la ligne de bit et de la ligne de référence, les dites lignes étant alors parcourues par des courants de décharge et une étape de production d'un signal de sortie dont l'état est représentatif des valeurs des courants de décharge.

Selon un mode de réalisation, les valeurs des courants de décharge sont commandées en fonction des valeurs des potentiels de la ligne de bit et de la ligne de référence, dans un sens tendant à augmenter la différence initiale entre les valeurs des dits potentiels.

Selon un mode de réalisation, les courants de décharge de la ligne de bit et de la ligne de référence sont convertis en un premier et un second potentiels secondaires dont les valeurs sont représentatives des valeurs respectives des potentiels de la ligne de bit et de la ligne de référence, et les potentiels secondaires sont comparés pour produire le signal de sortie.

Selon un mode de réalisation, le procédé comprend une étape d'amplification des valeurs des premier et second potentiels secondaires.

Selon un mode de réalisation; les potentiels secondaires commandent une augmentation des valeurs des courants de décharge de sorte à amplifier la différence de potentiel entre la ligne de bit et la ligne de référence.

Selon un mode de réalisation, la dite mémoire étant alimentée par un potentiel d'alimentation et par un potentiel de référence, l'amplification des potentiels secondaires est réalisée en amenant l'un des potentiels secondaires au niveau du potentiel d'alimentation et l'autre potentiel secondaire au niveau du potentiel de référence.

Selon un mode de réalisation, la valeur initiale du potentiel mémorisé dans la cellule de mémorisation étant sensiblement égale à la valeur du potentiel d'alimentation ou à la valeur du potentiel de référence, et le procédé comprenant une étape de rétablissement de la valeur initiale de ce potentiel mémorisé lorsque cette valeur initiale est sensiblement égale à la valeur du potentiel d'alimentation, l'étape de rétablissement est initiée par l'amplification du premier potentiel secondaire et est complétée en portant la valeur du potentiel de la ligne de bit à la valeur du potentiel d'alimentation.

L'invention concerne également une mémoire dynamique comprenant au moins une ligne de bit et une ligne de mot, au moins une cellule de mémorisation pour mémoriser un potentiel initial représentatif d'une information logique, ladite cellule étant accessible par le biais de la ligne de bit et de la ligne de mot, au moins une ligne de référence, cette ligne de référence pouvant être une seconde ligne de bit, des moyens pour précharger la ligne de bit et la ligne de référence de sorte à amener leur potentiel à une valeur de référence lors d'une phase de précharge, et des moyens de lecture pour produire, lors d'une phase de lecture, un signal de sortie représentatif du potentiel initial mémorisé dans la cellule de mémorisation. La mémoire comprend des moyens pour décharger les lignes de bit et de référence, lors de la phase de lecture, les dites lignes de bit et de référence étant alors parcourues par un premier et un second courants de décharge et le signal de sortie étant représentatif des valeurs des courants de décharge.

Selon un mode de réalisation, la mémoire comprend des moyens pour commander les valeurs des courants de décharge en fonction des valeurs des potentiels de la ligne de bit et de la ligne de référence dans un sens tendant à augmenter une différence initiale entre les valeurs des dits potentiels.

Selon un mode de réalisation, la mémoire comprend, d'une part, des moyens pour convertir le courant de décharge de la ligne de bit en un premier potentiel secondaire et pour convertir le courant de décharge parcourant la ligne de référence en un second potentiel secondaire et, d'autre part, un comparateur, ledit comparateur recevant les potentiels secondaires et produisant le signal logique de sortie.

Selon un mode de réalisation, la mémoire comprend un circuit de conversion courant - tension. Ce circuit comprend une première branche comprenant deux premiers transistors montés en série avec la ligne de bit, un premier de ces transistors, dit transistor de sélection, étant utilisé pour commander la décharge de la ligne de bit et un deuxième de ces transistor, dit transistor de conversion, produisant le premier potentiel secondaire lorsque le transistor de sélection de la première branche est passant. Il comprend également une seconde branche comprenant deux seconds transistors montés en série avec la ligne de référence, un premier de ces transistors, dit transistor de sélection, étant utilisé pour commander la décharge de la ligne de référence et un deuxième de ces transistors, dit transistor de conversion, produisant le second potentiel secondaire lorsque le transistor de sélection de la seconde branche est passant.

Selon un mode de réalisation, pour chaque branche du circuit de conversion courant - tension, le transistor de conversion a sa grille de commande reliée au drain du transistor de conversion de l'autre branche, de sorte qu'une modification du potentiel apparaissant sur la ligne de bit lors d'un transfert de charges entre la cellule de mémorisation et la ligne de bit induit une modification de la résistivité du transistor de conversion de la deuxième branche et, par suite, une modification dans un sens contraire de la résistivité du transistor de conversion de la première branche.

Selon un mode de réalisation, la mémoire comprend un premier circuit de lecture pour amplifier une différence de potentiel entre les potentiels secondaires, en diminuant la valeur de l'un de ces potentiels.

Selon un mode de réalisation, la mémoire comprend un deuxième circuit de lecture pour amplifier une différence de potentiel entre les potentiels secondaires, en augmentant la valeur de l'un de ces potentiels.

Selon un mode de réalisation, la dite mémoire étant alimentée par un potentiel d'alimentation et par un potentiel de référence, la valeur initiale du potentiel mémorisé dans la cellule de mémorisation étant sensiblement égale à la valeur du potentiel d'alimentation ou à la valeur du potentiel de référence, et la phase de lecture comprenant une étape de rétablissement de la valeur initiale du potentiel mémorisé lorsque cette valeur initiale est sensiblement égale à la valeur du potentiel d'alimentation, le rétablissement de la valeur initiale est réalisé par le deuxième circuit de lecture, au travers du transistor de sélection de la première branche du circuit de conversion, et la mémoire comprend un circuit de complément de précharge pour porter la valeur du potentiel de la ligne de bit au niveau de la valeur du potentiel d'alimentation et compléter ce rétablissement.

D'autres avantages et particularités apparaîtront à la lecture de la description qui suit d'un exemple de réalisation de l'invention, à lire conjointement aux dessins annexés dans lesquels :

- la figure 1 représente une cellule de mémorisation 2 classique de mémoire DRAM,
- la figure 2 représente schématiquement une mémoire DRAM,
- la figure 3 représente un exemple détaillé de dispositif de lecture mettant en oeuvre l'invention, et
- les figures 4a à 4g illustrent des chronogrammes de signaux de commande et de potentiel en rapport avec le dispositif de la figure 3.

La figure 2 représente schématiquement une mémoire DRAM 10 ayant une organisation en quinconce.

Dans l'exemple décrit, un signal logique à l'état haut aura un potentiel électrique égal à VCC, avec VCC un potentiel d'alimentation de la mémoire. Un signal logique à l'état bas aura un potentiel électrique égal à GND, avec GND un potentiel de référence (encore appelé potentiel de masse).

La mémoire est formée de M lignes de bit B1, B2,....., BM et de 2 * N lignes de mot W1, W2, ....., W2N-1, W2N. On supposera que M et N sont des entiers et que M est pair. Chaque ligne de bit comprend N cellules de mémorisation C1, C2 ..., CN accessibles par le biais de N lignes de mot. Ces cellules seront supposées être identiques à la cellule de mémorisation représentée sur la figure 1. Les cellules de mémorisation des lignes de bit paires B2, B4, ......, BM sont accessibles par le biais des lignes de mot paires W2, W4, ...., W2N et les cellules de mémorisation des lignes de bit impaires B1, B3, ......, BM-1 sont accessibles par le biais des lignes de mot impaires W1, W3, ...., W2N-1.

Dans une telle architecture, les lignes de bit sont regroupées deux par deux, l'une étant paire et l'autre impaire. De la sorte, lorsque l'on souhaite effectuer une lecture du contenu d'une cellule reliée à une ligne de bit, la ligne de bit associée est utilisée comme ligne de référence. Comme une ligne de mot donnée ne permet d'accéder qu'à une seule des deux lignes de bit, la ligne qui sert de ligne de référence présente, suite à la précharge, un potentiel stable mémorisé par la capacité équivalente de cette ligne. On notera que l'application de l'invention ne se limite pas au type d'architecture décrit. On pourra utiliser un autre type d'architecture, par exemple une architecture dans laquelle on utilise une ligne de référence dédiée ou faisant partie d'un autre plan de la mémoire si la mémoire est divisée en différents plans.

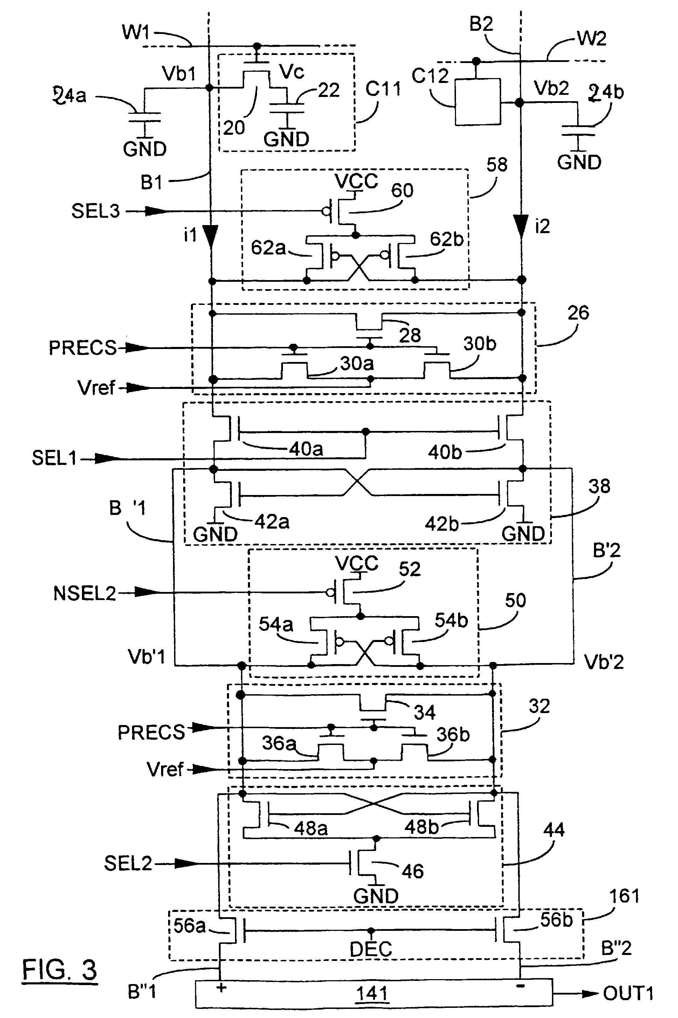

Chaque paire de lignes de bit (Bi, Bi+1) comprend un dispositif de lecture associé 12i, dont un exemple de réalisation est illustré sur la figure 3. Ce dispositif comprend des circuits de précharge, de lecture et de rafraîchissement. Ce dispositif fournit des signaux en tension Vbl'i et Vbl'i+1 à un comparateur 14i. Ce comparateur est utilisé pour produire un signal de sortie OUTi lorsque l'on accède en lecture au contenu d'une des cellules de mémorisation de la ligne de bit Bi ou de la ligne de bit Bi+1. Sur la figure 2, les signaux Vbl'i et Vbl'i+1 sont fournis par le biais d'un circuit de décodage 16i, ce qui permet d'utiliser un seul comparateur pour accéder à plusieurs paires de lignes de bit. Enfin, les dispositifs de lecture et de décodage et les lignes de mot sont pilotés par un dispositif de commande 18 qui leur fournit des signaux logiques de commande adéquats pour procéder à la lecture d'une cellule. On pourra, bien entendu, utiliser plusieurs comparateurs en parallèle si l'on souhaite accéder à plusieurs cellules de mémorisation en parallèle.

La figure 3 illustre un exemple détaillé de dispositif de lecture selon l'invention. On ne décrira pas en détail tous les circuits de la mémoire 10, tel par exemple, que la réalisation du dispositif de commande, la réalisation ce type de circuit ne devant pas poser de problème à l'homme du métier au vu de la description fonctionnelle donnée ci-après. On va s'attacher, plus particulièrement, à décrire les moyens et au procédé de lecture, auxquels se rapporte l'invention.

## 1 - Cellules de mémorisation.

Sur la figure 3, on a représenté deux lignes de bits B1 et B2, dites principales, et deux cellules de mémorisation C11 et C12 accessibles, respectivement, par le biais des lignes de bit B1 et B2 et de deux lignes de mot W1 et W2. Les cellules de mémorisation C11 et C12 sont identiques à celle illustrée sur la figure 1.

On va supposer, pour illustrer le procédé de lecture selon l'invention, que l'on souhaite lire le contenu de la cellule de mémorisation C11. La ligne de bit B2 sert alors de ligne de référence.

La cellule de mémorisation C11 comprend un transistor de sélection 20, de type MOS à canal N, et un condensateur 22 de mémorisation. La grille de commande du transistor de sélection 20 est reliée à la ligne de mot W1. Son drain est relié à la ligne de bit B1. Sa source est reliée à un premier pôle du condensateur de mémorisation 22. Ce condensateur a un deuxième pôle qui reçoit un potentiel de référence GND (encore appelé potentiel de masse). La cellule de mémorisation permet de mémoriser une information logique définie en fonction de la tension Vc présente aux bornes du condensateur de mémorisation 22, c'est-à-dire, en pratique, en fonction du potentiel initial Vc de son premier pôle. Ce potentiel initial, qui va être modifé lors de la lecture, est représentatif de l'information logique mémorisée. Typiquement, on peut stocker deux états logiques, un état bas et un état haut, selon que la tension aux bornes du condensateur est nulle ou non. Dans le premier cas, on aura $Vc = V(0) = GND = 0$. Dans le second cas, on aura $Vc = V(1) > 0$. On choisira, par exemple, $V(1) = VCC$.

La cellule de mémorisation C12, non représentée en détail, aura une structure analogue à la structure de la cellule C11. Par ailleurs, les lignes de bit B1 et B2 permettront d'accéder à N-1 autres cellules, non représentées sur la figure 3.

Les lignes de bit B1 et B2 présentent chacune une capacité parasite équivalente. Ces capacités sont sensiblement égales pour les deux lignes de bit, en supposant bien entendu que les lignes de bit ont des dimensions sensiblement identiques. Sur la figure 3, ces capacités parasites sont représentées par des condensateurs parasites 24a et 24b recevant le potentiel de référence GND sur un pôle et ayant un autre pôle relié, respectivement, à la ligne de bit B1 et à la ligne de bit B2. On notera Vb1 et Vb2 les potentiels présents sur les lignes de bit B1 et B2. autrement dit les tensions aux bornes des condensateurs parasites 24a et 24b.

La lecture de l'information mémorisée dans la cellule de mémorisation C11 comprendra, principalement, des étapes de précharge et d'équilibrage des lignes de bit, de production d'un signal de sortie représentatif de cette information, et de rafraîchissement de l'information initiale.

## 2 - Circuits de précharge.

Dans le dispositif de lecture selon l'invention, on utilise, outre les lignes de bit principales, des lignes de bit B'1 et B'2, dites secondaires. Ces lignes secondaires B'1 et B'2 sont reliées, respectivement, aux lignes de bit principales B1 et B2, par le biais d'un circuit de conversion courant / tension qui fait office de préamplificateur de lecture. La production de signaux de sortie se fera à partir des potentiels Vb'1 et Vb'2, dit secondaires, présents sur les lignes de bit secondaires. Comme on le verra par la suite, le circuit de conversion courant / tension permet, d'une part. d'isoler capacitivement les lignes de bit principales des lignes de bit secondaires et, d'autre part, d'amplifier la différence de potentiel entre les lignes de bit principales, lorsque l'on procède à une lecture.

Le dispositif de lecture illustré comprend un circuit 26 de précharge des lignes de bit principales.

Ce circuit 26 permet de précharger les lignes de bit principales, c'est-à-dire de positionner les potentiels Vb1 et Vb2 au niveau d'une valeur de potentiel de référence Vref. En pratique, cette valeur de référence sera mémorisée par les condensateurs parasites 24a et 24b et sera différente des valeurs pouvant être prises par le potentiel initial mémorisé dans la cellule C11. Typiquement, on choisira une valeur de référence intermédiaire entre les valeurs de potentiel V(0) et V(1) représentatives des états stockés par les cellules de mémorisation. Cela permet d'assurer des temps d'accès à un état mémorisé dans une cellule qui soient sensiblement égaux quel que soit cet état, bas ou haut. Dans l'exemple, comme on a $V(1) = VCC$ et $V(0) = GND$, on choisira $Vref = VCC/2$. Ainsi, quand on accédera au contenu d'une cellule de la ligne de bit Bi, la modification induite du potentiel Vbi sera symétrique par rapport au potentiel de référence Vref.

Le dispositif de précharge 26 comprend également des moyens d'équilibrage pour équilibrer les potentiels des lignes de bit lorsqu'elles sont préchargées. Cela permet également de garantir des temps d'accès, aux états stockés, qui soient sensiblement égaux, quels que soient les valeurs des états stockés. En effet, une fois que les lignes de bit B1 et B2 sont préchargées et qu'une cellule à lire est sélectionnée, la différence de potentiel Vb1 - Vb2 sera sensiblement égale, en valeur absolue, quelle que soit la modification apportée au potentiel Vb1 ou Vb2.

Le circuit 26 comprend trois transistors 28, 30a et 30b, de type MOS à canal N. Ces transistors reçoivent un signal logique de commande de précharge PRECS sur leur grille de commande. Le positionnement à l'état haut de ce signal permet de précharger les lignes de bit B1 et B2 et d'équilibrer les potentiels de ces lignes. Le canal du transistor 28 est monté entre les lignes de bit principales B1 et B2 et permet d'égaliser leurs potentiels quand ce transistor est passant. Les sources des transistors 30a et 30b sont reliées entre elles et reçoivent le potentiel de référence Vref. Les drains des transistors 30a et 30b sont reliés, respectivement, aux lignes de bit B1 et B2. Ces transistors permettent de précharger les lignes de bit principales lorsqu'ils sont passants.

Le dispositif de lecture comprend, par ailleurs, un circuit 32 de précharge des lignes de bit secondaires B'1 et B'2.

Le circuit 32 comprend trois transistors 34, 36a et 36b, de type MOS à canal N. Ces transistors reçoivent un signal logique de commande sur leurs grilles de commande. Dans l'exemple illustré, on choisit de précharger simultanément les lignes de bit principales et secondaires, et le signal de commande reçu est donc le signal PRECS. On pourra cependant utiliser des signaux de commande de précharge distincts. Les lignes de bit secondaires supportant, en pratique, des charges capacitives moins élevées que les lignes de bit principales, on pourra, par exemple, les précharger plus tardivement que les lignes de bit principales.

Le canal du transistor 34 est monté entre les lignes de bit secondaires B'1 et B'2. Ce transistor permet d'égaliser les potentiels des lignes de bit secondaires lorsque l'on réalise la précharge de ces lignes. Les sources des transistors 36a et 36b sont reliées entre elles et reçoivent le potentiel de précharge Vref. Les drains de ces transistors sont reliés, respectivement, aux lignes de bit B'1 et B'2. Ces transistors permettent de porter les potentiels des lignes de bit secondaires à la valeur de référence, c'est-à-dire à VCC/2.

**3 - Circuits de lecture et de rafraîchissement.**

Le dispositif de lecture comprend un circuit 38 de conversion courant / tension. Ce circuit 38 sera utilisé en tant que préamplificateur de lecture. D'autre part, comme on le verra ultérieurement, des transistors de ce circuit assureront concurremment une fonction de filtrage entre les lignes de bit principales et secondaires.

Le circuit 38 comprend quatre transistors 40a, 40b, 42a et 42b, de type MOS à canal N. Les deux transistors 40a et 40b, de type MOS à canal N, reçoivent un premier signal de commande de lecture SEL1 sur leur grille de commande. Le drain du transistor 40a est relié à la ligne de bit principale B1 et sa source est reliée à une ligne de bit secondaire B'1. Le drain du transistor 40b est relié à la ligne de bit principale B2 et sa source est reliée une ligne de bit secondaire B'2. Pour rendre passants les transistors 40a et 40b, il suffit par exemple de positionner le signal SEL1 à l'état haut.

Les transistors 40a et 40b, dits de sélection, permettent d'isoler les lignes de bit principales des lignes de bit secondaires, lors de la précharge de ces lignes de bit. Comme on le verra par la suite, ces transistors seront rendus passants pour permettre une décharge des lignes de bit principales.

Les transistors de sélection 40a et 40b assurent également un rôle de filtrage. Il est possible que les lignes de bit principales soient soumises à des phénomènes parasites. Ces phénomènes pourront se présenter sous la forme d'impulsions provenant, par exemple, de la mise en conduction ou hors conduction de transistors reliés à ces lignes de bit, ou bien encore de bruit au niveau des potentiels d'alimentation et de référence. Ces phénomènes peuvent induire des erreurs de lecture, si les circuits de lecture produisant les signaux de sortie sont soumis à ces phénomènes parasites. Les transistors 40a et 40b permettent de filtrer ces éventuels phénomènes parasites.

Par ailleurs, comme on l'a mentionné précédemment, les lignes de bit ont, du fait de leur longueur qui est généralement importante, une capacité équivalente qui est de l'ordre du picofarad. L'utilisation de lignes de bit secondaires permet de minimiser les capacités vues par les circuits de lecture. En effet, ces lignes de bit secondaires ne sont reliées qu'aux circuits de lecture et ces circuits occupent une surface limitée par rapport à la surface occupée par les cellules de mémorisation. En découplant, d'un point de vue capacitif, les lignes de bit principales et les circuits de lecture, on peut donc diminuer les délais d'accès aux informations stockées dans les cellules.

Le drain du transistor 42a est relié, d'une part, à la source du transistor 40a et, d'autre part, à la grille de commande du transistor 42b. Sa source reçoit le potentiel de référence GND. Le drain du transistor 42b est relié, d'une part, à la source du transistor 40b et, d'autre part, à la grille de commande du transistor 42a. Sa source reçoit le potentiel de référence GND. Les transistors 42a et 42b, dits de conversion, seront utilisés pour moduler des courants de décharge i1 et i2 des lignes de bit principales B1 et B2, et pour convertir ces courants en une différence de potentiel, cette différence de potentiel étant ensuite utilisée pour produire un signal de sortie.

Le dispositif de lecture comprend également un premier circuit 44 de lecture et de rafraîchissement. Ce circuit 44 est relié aux lignes de bit secondaires. Il permet d'amplifier une différence entre les potentiels secondaires et, plus particulièrement, de diminuer l'un des potentiels secondaires en l'amenant au niveau du potentiel de référence GND. Il permet également de procéder au rafraîchissement du contenu de la cellule lue lorsque celle-ci stockait initialement un état bas. Comme on l'a mentionné, la lecture de l'état d'une cellule de mémorisation induit une modification de la tension présente initialement aux bornes de son condensateur de mémorisation. Il est donc préférable de prévoir une étape de rétablissement de la tension initiale lors de la lecture.

Le circuit 44 comprend trois transistors 46, 48a et 48b, de type MOS à canal N. Le transistor 44 reçoit, sur sa source, le potentiel de référence GND. Sa grille de commande reçoit un deuxième signal logique de commande de lecture SEL2. Son drain est relié aux sources des transistors 48a et 48b. Le drain et la grille de commande du transistor 48a sont reliés, respectivement, à la ligne de bit B'1 et au drain du transistor 48b.

Le drain et la grille de commande du transistor 48b sont reliés, respectivement, à la ligne de bit B'2 et au drain du transistor 48a.

Le dispositif de lecture comprend également un deuxième circuit 50 de lecture et de rafraîchissement. Ce circuit 50 est également relié aux lignes de bit secondaires. Le circuit 50 permet d'amplifier une différence entre les potentiels secondaires et, plus particulièrement, d'augmenter la valeur d'un de ces potentiels en l'amenant au niveau du potentiel d'alimentation VCC. Il permet également d'initier le rafraîchissement du contenu de la cellule lue lorsque celle-ci stockait initialement un état haut.

Le circuit 50 comprend trois transistors 52, 54a et 54b, de type MOS à canal P. Le transistor 52 reçoit le potentiel d'alimentation VCC sur sa source. Sa grille de commande reçoit un troisième signal logique de commande de lecture NSEL2. Dans un exemple, le signal NSEL2 sera obtenu par inversion du deuxième signal de commande de lecture SEL2.

Le drain du transistor 52 drain est relié aux sources des transistors 54a et 54b. Le drain et la grille de commande du transistor 54a sont reliés, respectivement, à la ligne de bit secondaire B'1 et au drain du transistor 54b. Le drain et la grille de commande du transistor 54b sont reliés, respectivement, à la ligne de bit secondaire B'2 et au drain du transistor 54a.

Les lignes de bit secondaire sont reliées à un comparateur 141 par le biais d'un circuit de décodage 161.

Le circuit 161 de décodage permet d'isoler les lignes de bit secondaires du comparateur de lecture 141. La présence du circuit 161 n'est pas nécessaire, en toute rigueur, mais il permet d'utiliser le comparateur 141 pour lire plusieurs groupes de lignes de bit. Il peut également isoler le comparateur des lignes de bit lorsque celles-ci sont reliées à des dispositifs d'écriture pour stocker les informations dans les cellules de mémorisation. L'utilisation d'un circuit de décodage permet également de retarder la production d'un signal de sortie par le comparateur. On peut ainsi attendre, en lecture, que les potentiels des lignes de bit secondaires s'établissent à des valeurs suffisamment distinctes, pour minimiser le risque de production d'un signal de sortie erroné.

Le circuit de décodage 161 comprend deux transistors 56a et 56b, de type MOS à canal N, dont les drains sont reliés aux lignes B'1 et B'2, dont les sources sont reliées à des lignes B''1 et B''2, dites de sortie, et dont les grilles de commande reçoivent un signal logique de commande de sélection DEC. Lorsque le signal DEC est à l'état haut, les transistors 56a et 56b sont passants. Lorsque ce signal est à l'état bas, les dits transistors sont bloqués.

Les lignes de sortie B''1 et B''2 sont reliées à des entrées du comparateur de lecture 141, non représenté en détail, qui produit sur une sortie un signal logique de sortie OUT1. L'état du signal OUT1 est représentatif des valeurs respectives des potentiels secondaires présents sur les lignes B''1 et B''2, c'est-à-dire des valeurs des courants de décharge i1 et i2 et, par suite, de l'état mémorisé initialement dans la cellule lue. On supposera que la ligne de sortie B''1 est reliée à une entrée + du comparateur 141 et que la ligne de sortie B''2 est reliée à une entrée - de ce comparateur.

Le dispositif de lecture comprend, enfin, un circuit 58 de complément de rafraîchissement. Ce circuit 58 est relié aux lignes de bit principales et permet d'augmenter, si nécessaire, un potentiel de rafraîchissement fourni par le circuit 50 de lecture et de précharge.

Le circuit 58 comprend trois transistors 60, 62a et 62b, de type MOS à canal P. Le transistor 60 reçoit le potentiel d'alimentation VCC sur sa source. Sa grille de commande reçoit un signal de commande de rafraîchissement SEL3. Son drain est relié aux sources des transistors 62a et 62b. Le drain et la grille de commande du transistor 62a sont reliés, respectivement, à la ligne de bit B1 et au drain du transistor 62b. Le drain et la grille de commande du transistor 62b sont reliés, respectivement, à la ligne de bit B2 et au drain du transistor 62a.

## 4 - Procédé de lecture mis en oeuvre.

On va maintenant décrire une opération de lecture selon l'invention.

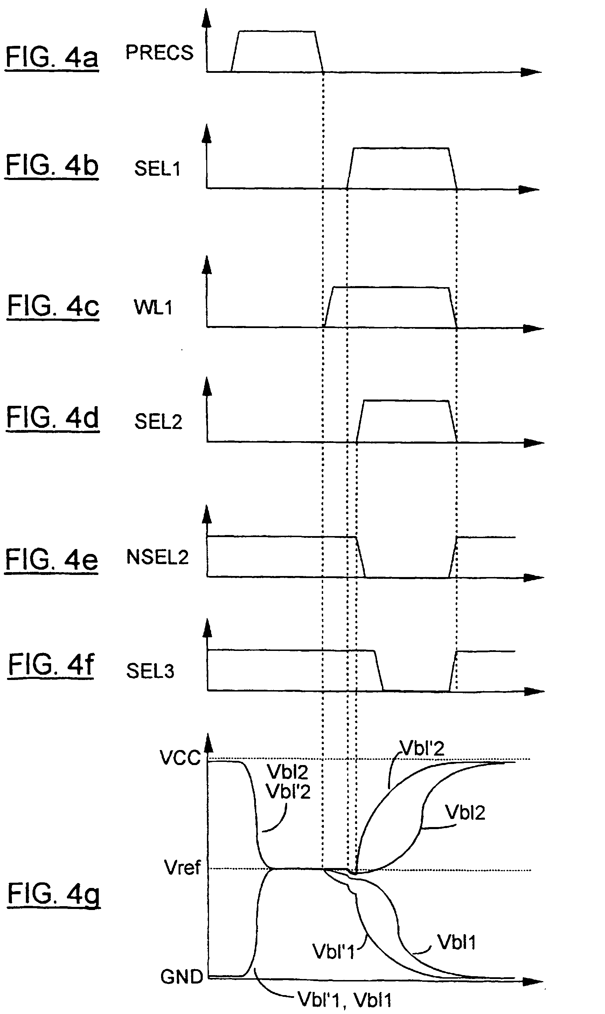

On pourra se reporter aux figures 4a à 4g qui illustrent des chronogrammes de signaux de commande et de potentiel lors d'une lecture, plus particulièrement lorsque l'on lit un état logique 0. Les figures 4a, 4b, 4d, 4e et 4f illustrent, respectivement, les signaux PRECS, SEL1, SEL2, NSEL2 et SEL3. La figure 4c illustre le potentiel de la ligne de mot W1. La figure 4g illustre les potentiel Vb1, Vb2, Vb'1 et Vb'2, avec Vb1 et Vb2 les potentiels des lignes de bit principales B1 et B2, et Vb'1 et Vb'2 les potentiels des lignes de bit secondaires B'1 et B'2.

On supposera qu'initialement les lignes de bit principales et secondaires sont isolées entre elles et des différents circuits mentionnés. On aura ainsi PRECS = 0, SEL1 = 0, SEL2 = 0, NSEL2 = 1, SEL3 = 1 et DEC = 0. La cellule C11 n'est pas sélectionnée, autrement dit la ligne de mot WI est portée à un potentiel tel que le condensateur 22 de la cellule C11 est isolé de la ligne de bit principale B1 (ce potentiel est, par exemple, égal au potentiel GND).

On rappelle que l'on souhaite lire l'état mémorisé dans la cellule C11, la ligne de bit principale B2 étant utilisée comme ligne de référence. Enfin, on supposera que les potentiels des lignes de bit B1 et B'1 sont sensiblement égaux au potentiel de référence, et que les potentiels des lignes B2 et B'2 sont sensiblement égaux au potentiel VCC. Cela correspond, comme on pourra le voir, au résultat d'une lecture antérieure. On pourra également supposer, quoiqu'il en soit, que toutes ces lignes sont déchargées et ont un potentiel sensiblement égal au potentiel de référence.

Pour mettre en oeuvre une lecture, on va tout d'abord précharger les lignes de bit principales et secondaires en positionnant le signal PRECS à l'état haut. Les potentiels des lignes de bit principales et secondaires sont portées à la valeur Vref = VCC/2, par la charge des capacités parasites de ces lignes. Les lignes de bit principales B1 et B2 sont préchargées par le biais des transistors 30a et 30b. Les lignes de bit secondaires B'1 et B'2 sont préchargées par le biais des transistors 36a et 36b.

Les transistors 28 et 34 permettent d'équilibrer les potentiels des lignes de bit entre eux, lors de la précharge.

Une fois la précharge terminée, la lecture proprement dite va être effectuée. On pourra considérer que la précharge est terminée lorsqu'un délai donné se sera écoulé. En effet, connaissant la charge capacitive théorique des lignes de bit principales et secondaires, on peut en déduire le délai théorique nécessaire pour amener les lignes de bit au potentiel de référence. On pourra, aussi, mesurer le potentiel des lignes de bit pour s'assurer que les potentiels des lignes ont atteint la valeur de référence souhaitée.

Une fois la valeur de précharge atteinte, on isole les lignes de bit des circuits de précharge, en positionnant le signal de commande PRECS à l'état bas. Le potentiel des lignes de bit est alors maintenu dans les lignes de bit par effet capacitif.

La lecture proprement dite commence en sélectionnant la ligne de mot W1, autrement dit en rendant passant le transistor 20 pour accéder au contenu de la cellule. Si le condensateur de stockage de la cellule C11 est chargé, on va assister à un transfert de charges vers la ligne de bit principale B1. Le potentiel de cette ligne va avoir tendance, dans un premier temps, à augmenter. Si ce condensateur de mémorisation n'est pas chargé, on va assister à un transfert de charges vers la cellule de mémorisation et à une chute du potentiel de la ligne de bit principale B 1.

Puis, on positionne le signal SEL1 à l'état haut, c'est-à-dire à VCC. On va donc décharger les capacités équivalentes des lignes de bit dans les transistors 42a et 42b du circuit de conversion 38, les transistors 40a et 40b étant passants. En effet, ces transistors 42a et 42b étant soumis à une différence de potentiel source - grille sensiblement égale à VCC/2, ils sont passants.

Les potentiels des lignes de bit principales vont donc tendre à atteindre la valeur de référence GND. Pour éviter une décharge trop rapide des lignes de bit principales, on choisira des transistors 40a et 40b suffisamment résistifs, dont le dimensionnement dépendra des temps de réaction des circuits de lecture et de la valeur des capacités parasites des lignes de bit principales qui, une fois préchargées à la valeur Vref, forment des sources de courant temporaires.

Comme il existe une différence de potentiel entre les lignes de bit principales, les courants de décharge i1 et i2 parcourant les lignes B1 et B2 vont être différents et on va créer une différence de potentiel sur les lignes de bit secondaires. Cette différence de potentiel est ensuite amplifiée en positionnant le signal SEL2 à l'état haut et le signal NSEL2 à l'état bas.

On va maintenant considérer les opérations de lecture et le rafraîchissement en fonction de l'état mémorisé initialement dans la cellule de mémorisation C11.

**- Lecture d'un état logique 0.**

Supposons que l'on a initialement Vc = GND. Lorsque le transistor 20 devient passant, il y a un transfert de charges vers la cellule de mémorisation et une chute de potentiel Vb1 de la ligne de bit B1.

Supposons que les transistors 40a et 40b deviennent passants.

La différence de potentiel grille - source du transistor 42b sera inférieure à la différence de potentiel grille - source du transistor 42a. Les potentiels positifs appliqués aux sources de ces transistors 42a et 42b étant identiques et fixes, le transistor 42b va devenir plus résistif que le transistor 42a. De ce fait, le courant de décharge il parcourant la branche formée des transistors 40a et 42a sera plus important. Le potentiel présent sur le drain du transistor 42a va donc diminuer plus rapidement que le potentiel présent sur le drain du transistor 42b. On aura donc tendance, également, à rendre le transistor 40a moins résistif que le transistor 40b, ce qui amplifie la différence de conductivité des branches du circuit 38.

Ainsi, à partir d'une différence transitoire de tension de l'ordre de 10 % dans les lignes de bit principales, on va tendre à créer une différence de potentiel plus grande, par exemple de l'ordre de 4 à 5 fois plus importante, sur les lignes de bit secondaires, en modulant les courants de décharge i1 et i2 des lignes de bit principales.

Peu après, on positionne le signal SEL2 à l'état haut et, parallèlement, le signal NSEL2 à l'état bas. On pourrait procéder au changement d'état du signal SEL2 dès que les transistors 40a et 40b deviennent passants. Cela étant, il est préférable de retarder légèrement la lecture pour éviter une lecture erronée, la différence de potentiel entre les lignes de bit secondaires étant peu importante en début de décharge des lignes de bit principales. Lorsque les signaux SEL2 et NSEL2 sont, respectivement, à l'état haut et à l'état bas, les transistors 46 et 52 deviennent passants.

Le circuit de lecture 44 va amplifier la différence de potentiel entre les lignes de bit secondaires, en amenant la valeur du potentiel secondaire Vb'1 à GND. La ligne de bit secondaire B'2 étant à un potentiel secondaire Vb'2 plus élevé que la ligne B'1, le potentiel Vb'1 présent sur le drain du transistor 48a va chuter plus rapidement que le potentiel Vb'2 présent sur le drain du transistor 48b. De ce fait, le potentiel Vb'1 de la ligne de bit secondaire B'1 va être amené au potentiel GND, au travers des transistors 48a et 46, ce qui va entraîner une augmentation de la résistivité du transistor 48b.

Parallèlement, le signal NSEL2 étant à l'état bas, les transistors 54a et 54b reçoivent le potentiel d'alimentation VCC sur leurs sources. La différence de potentiel grille - source du transistor 54b étant plus importante que celle du transistor 54a, le potentiel Vb'2 de la ligne de bit secondaire de référence B'2 va augmenter pour atteindre la valeur de VCC. Parallèlement, le transistor 54a va se bloquer, ce qui maintiendra le potentiel de la ligne de bit secondaire B'1 au potentiel GND. Le circuit 50 permet ainsi d'amplifier la différence de potentiel entre les lignes de bit secondaires, en amenant le potentiel Vb'2 au niveau de VCC.

En positionnant le signal DEC à l'état haut, on va rendre les transistors 56a et 56b passants. Le comparateur 141 reçoit alors sur ses entrées les potentiels secondaires des lignes B'1 et B'2 et produira un signal de sortie OUT1 dont l'état sera représentatif de l'état initial de la cellule C11. Si on suppose que la ligne B"1 est connectée à l'entrée + du comparateur, celui-ci étant alimenté par les potentiels VCC et GND, le signal OUT1 sera à l'état bas.

Lorsque l'on lit un état logique 0, on remarquera que le rafraîchissement du contenu de la cellule C11 est effectué en même temps que la lecture. Effectivement, la lecture s'effectue en déchargeant la ligne de bit principale B1 et le condensateur de mémorisation 22. Si la mise en oeuvre de la lecture s'accompagne initialement d'une augmentation de la tension aux bornes du condensateur de mémorisation, cette augmentation étant due au transfert de charges vers la cellule de mémorisation, elle est suivie d'une chute de cette tension une fois que les tensions sont équilibrées sur la ligne de bit et aux bornes de ce condensateur. On décharge alors à la fois la ligne de bit B1 et le condensateur de mémorisation 22. On remarquera que le circuit 44 permet d'augmenter le potentiel de la grille de commande du transistor 42a et de le porter à la valeur de VCC. En supposant que la mémoire est alimentée uniquement par les potentiels VCC et GND, on assure alors une différence de potentiel grille - source maximale pour les transistors 40a et 42a dont les canaux sont montés en série entre le premier pôle du condensateur de mémorisation 22 et la masse. Ces transistors sont donc les plus passants possibles, ce qui permet de garantir un délai de rafraîchissement minimal. Dans le cas d'une lecture d'un état logique 0, le procédé selon l'invention permet diminuer la durée de la lecture et celle du rafraîchissement.

**- Lecture d'un état logique 1.**

Supposons que l'on a initialement Vc = VCC. De même que précédemment, on procède à la décharge des lignes de bit principales au travers des transistors du circuit 38. Les potentiels Vb1 et Vb2 de ces lignes de bit vont donc chuter plus ou moins rapidement, en fonction de la résistivité des transistors du circuit 38.

Lorsque la ligne de mot WI est sélectionnée, on assiste à un transfert de charges de la cellule de mémorisation C11 vers la ligne de bit B1. Ce transfert de charges s'accompagne d'une augmentation provisoire du potentiel Vb1 de cette ligne de bit. Lorsque les transistors 40a et 40b deviennent passants, la différence de potentiel grille - source est alors plus importante pour le transistor 42b que pour le transistor 42a. Le transistor 42b va donc devenir moins résistif que le transistor 42a. Le courant de décharge i2 sera donc plus important. De ce fait, les potentiels des lignes de bit B2 et B'2 vont chuter, pour atteindre le potentiel GND, plus rapidement que les potentiels des lignes de bit B1 et B'1.

Quand les transistors 46 et 52 deviennent passants, le transistor 48a reçoit sur sa grille de commande un potentiel moins élevé que le transistor 48b. Le transistor 48a est alors plus résistif que le transistor 48b. On amplifie alors la différence de potentiel Vb'1 - Vb'2 entre les lignes de bit secondaires, en amenant le potentiel Vb'2 au niveau du potentiel GND.

De même que précédemment, la différence de potentiel entre les lignes B'1 et B'2 va être amplifiée par le circuit 50. Le potentiel Vb'1 de la ligne de bit B'1 va atteindre la valeur de VCC, par le biais du transistor 54a. Le transistor 54b, quant à lui, va se bloquer.

En positionnant le signal DEC à l'état haut, on va rendre les transistors 56a et 56b passants. Le comparateur 141 reçoit alors sur ses entrées les potentiels secondaires Vb'1 et Vb'2 et produit un signal logique de sortie OUT1 dont l'état haut est représentatif de l'état initial de la cellule C11.

Concurremment à l'accélération de la lecture, le circuit 50 va participer au rafraîchissement du contenu de la cellule C11, c'est-à-dire au rétablissement du potentiel initial mémorisé dans la cellule. Ce rafraîchissement est d'autant plus important que la lecture selon l'invention est destructrice. En effet, lorsque l'on rend passant le transistor 40a on va assister à un déchargement de la ligne de bit et du condensateur de mémorisation, ce qui n'était pas le cas dans les circuits de l'état de l'art.

Les transistors 52 et 54a, outre qu'ils amplifient la différence de potentiel initiale des lignes de bit secondaires en fournissant le potentiel VCC à une entrée du comparateur 141, fournissent également ce potentiel à la ligne de bit B1, par le biais du transistor 40a. On va donc ainsi recharger le condensateur de mémorisation 22 de sorte que le potentiel de son premier pôle remonte à la valeur de VCC.

En réalité, il convient de tenir compte de la chute de tension dans le canal du transistor 40a. Une première solution, pour tenir compte de ce problème, est de porter le signal de commande SEL1 à un potentiel suffisant pour annuler cette chute de tension. Si on souhaite réaliser une mémoire alimentée uniquement par le biais des potentiels VCC et GND, cela suppose que l'on prévoit un circuit de rehaussement de tension, ce qui est pénalisant en terme de surface occupée. Dans l'exemple illustré, on utilise le circuit 58 pour compléter le rafraîchissement du contenu de la cellule Ci1, par le biais de ses transistors 60 et 62a. Il n'est donc pas nécessaire de produire de potentiel supérieur à VCC.

Le complément de rafraîchissement se commande en positionnant le signal SEL3 à l'état bas. Le transistor 60 devient passant et les transistors 62a et 62b reçoivent le potentiel VCC sur leur source. Les potentiels reçus par les grilles de ces transistors sont déséquilibrés. Le transistor 62a a une différence de potentiel grille - source plus importante. Il est donc plus passant que le transistor 62b. De ce fait, le potentiel VCC va s'imposer sur le drain du transistor 62a et le transistor 62b va être bloqué. Le potentiel de la ligne B1 va alors monter à VCC, par le biais des transistors 60 et 62a, et compléter le rafraîchissement initialisé par le circuit de lecture 50. On remarquera que l'on pourrait se passer du circuit de lecture 50. On utilisera alors le circuit 44 pour la lecture et le circuit 58 pour le rafraîchissement. Cela permet de diminuer la surface occupée par les dispositifs de lecture et de rafraîchissement. Par contre, l'exemple illustré présente un avantage en terme de rapidité puisque le circuit 50 permet, en lecture, de bénéficier d'une différence de potentiel plus importante sur les entrées du comparateur 141.

En pratique, pour la lecture d'un état logique 1, la lecture et le rafraîchissement seront différenciées. On pourra obtenir une lecture plus rapide, de manière analogue à ce qui a été dit pour la lecture d'un état 0. Par contre, compte tenu de la décharge de la ligne de bit et du condensateur de mémorisation au travers des transistors 40a et 42b, on procédera à un rafraîchissement un peu moins rapide, toutes choses étant égales par ailleurs.

Si on souhaite lire le contenu d'une cellule de mémorisation rattachée à la ligne de bit principale B2, le procédé mis en oeuvre sera identique. La ligne de bit principale B1 sera alors utilisée comme ligne de référence. La seule différence avec l'exemple illustré en détail sera la valeur du signal OUT1 en fonction de l'état stocké dans la cellule lue. En effet, si la cellule lue mémorisait initialement un état 0 alors on aura OUT1 = VCC. Si elle mémorisait un état 1, on aura OUT1 = GND. Pour harmoniser la valeur du signal de sortie produit par le comparateur 141, on pourra prévoir d'utiliser un circuit supplémentaire pour inverser le signal de sortie produit, si on lit le contenu d'une cellule rattachée à une ligne de bit paire, et pour ne pas l'inverser, dans le cas contraire.

On notera que l'on pourra modifier la chronologie des signaux de commande. Dans l'exemple décrit, la sélection de la cellule précède la décharge des lignes de bit. On pourra cependant opérer différemment et commencer par décharger les lignes de bits avant de sélectionner la cellule. Cette dernière sélection devra, bien entendu, s'opérer rapidement. La modulation des courants de décharge suppose, en effet, que ces courants aient des valeurs non nulles, c'est-à-dire que les lignes ne soient pas déjà déchargées. On pourra aussi procéder simultanément à la sélection et à la commande de décharge.

## Revendications

1. Procédé de lecture d'une mémoire dynamique comprenant au moins une ligne de bit (B1), une ligne de mot (W1), une cellule de mémorisation (C11) accessible par le biais de la ligne de bit et de la ligne de mot, et une ligne de référence (B2), la cellule de mémorisation permettant de mémoriser un potentiel initial (Vc) représentatif d'une information logique,

   ledit procédé comprenant :

   - une étape de précharge de la ligne de bit (B1) et de la ligne de référence (B2) pour porter le potentiel (Vb1, Vb2) de ces lignes au niveau d'un potentiel de référence (Vref) différent du potentiel initial mémorisé dans la cellule de mémorisation (C11),
   - une étape de sélection de la cellule de mémorisation (C11) pour produire une modification du potentiel (Vb1) de la ligne de bit (B1) et créer ainsi une différence initiale entre les potentiels de la ligne de bit et de la ligne de référence (B2), et

     caractérisé en ce qu'il comprend une étape de décharge de la ligne de bit et de la ligne de référence, les dites lignes étant alors parcourues par des courants de décharge (i1, i2) et une étape de production d'un signal de sortie (OUT1) dont l'état est représentatif des valeurs des courants de décharge.

2. Procédé selon la revendication 1, caractérisé en ce que les valeurs des courants de décharge sont commandées en fonction des valeurs des potentiels de la ligne de bit et de la ligne de référence, dans un sens tendant à augmenter la différence initiale entre les valeurs des dits potentiels.

3. Procédé selon l'une des revendications 1 ou 2, caractérisé en ce que les courants de décharge de la ligne de bit et de la ligne de référence sont convertis en un premier et un second potentiels secondaires (Vb'1, Vb'2) dont les valeurs sont représentatives des valeurs respectives des potentiels de la ligne de bit et de la ligne de référence, et en ce que les potentiels secondaires sont comparés pour produire le signal de sortie (OUT1).

4. Procédé selon la revendication 3, caractérisé en ce qu'il comprend une étape d'amplification des valeurs des premier et second potentiels secondaires.

**5.** Procédé selon la revendication 4, caractérisé en ce que les potentiels secondaires commandent une augmentation des valeurs des courants de décharge de sorte à amplifier la différence de potentiel entre la ligne de bit et la ligne de référence.

**6.** Procédé selon l'une des revendications 4 ou 5, la dite mémoire étant alimentée par un potentiel d'alimentation (VCC) et par un potentiel de référence (GND), caractérisé en ce que l'amplification des potentiels secondaires est réalisée en amenant l'un des potentiels secondaires au niveau du potentiel d'alimentation et l'autre potentiel secondaire au niveau du potentiel de référence.

**7.** Procédé selon la revendication 6, la valeur initiale du potentiel mémorisé dans la cellule de mémorisation étant sensiblement égale à la valeur du potentiel d'alimentation ou à la valeur du potentiel de référence, et le procédé comprenant une étape de rétablissement de la valeur initiale de ce potentiel mémorisé lorsque cette valeur initiale est sensiblement égale à la valeur du potentiel d'alimentation, caractérisé en ce que ladite étape est initiée par l'amplification du premier potentiel secondaire et est complétée en portant la valeur du potentiel de la ligne de bit à la valeur du potentiel d'alimentation.

**8.** Mémoire dynamique comprenant

- au moins une ligne de bit (B1) et une ligne de mot (W1),
- au moins une cellule de mémorisation (C11) pour mémoriser un potentiel initial (Vc) représentatif d'une information logique, ladite cellule étant accessible par le biais de la ligne de bit et de la ligne de mot,
- au moins une ligne de référence (B2), cette ligne de référence pouvant être une seconde ligne de bit,
- des moyens (26) pour précharger la ligne de bit et la ligne de référence de sorte à amener leur potentiel à une valeur de référence (Vref) lors d'une phase de précharge, et
- des moyens de lecture (44, 50, 141) pour produire, lors d'une phase de lecture, un signal de sortie (OUT1) représentatif du potentiel initial mémorisé dans la cellule de mémorisation,

caractérisée en ce que la mémoire comprend des moyens (42a, 42b) pour décharger les lignes de bit et de référence, lors de la phase de lecture, les dites lignes de bit et de référence (B1, B2) étant alors parcourues par un premier et un second courants de décharge (i1, i2) et le signal de sortie (OUT1) étant représentatif des valeurs des courants de décharge.

**9.** Mémoire selon la revendication 8, caractérisée en ce qu'elle comprend des moyens (42a, 42b) pour commander les valeurs des courants de décharge en fonction des valeurs des potentiels de la ligne de bit et de la ligne de référence dans un sens tendant à augmenter une différence initiale entre les valeurs des dits potentiels.

**10.** Mémoire selon l'une des revendications 8 ou 9, caractérisée en ce qu'elle comprend, d'une part, des moyens (42a, 42b) pour convertir le courant de décharge de la ligne de bit en un premier potentiel secondaire (Vb'1) et pour convertir le courant de décharge parcourant la ligne de référence en un second potentiel secondaire (Vb'2) et, d'autre part, un comparateur (141), ledit comparateur recevant les potentiels secondaires et produisant le signal logique de sortie.

**11.** Mémoire selon la revendication 10, caractérisée en ce qu'elle comprend un circuit de conversion courant - tension (38) comprenant :

- une première branche comprenant deux premiers transistors (40a, 42a) montés en série avec la ligne de bit (B1), un premier (40a) de ces transistors, dit transistor sélection, étant utilisé pour commander la décharge de la ligne de bit et un deuxième (42a) de ces transistor, dit transistor de conversion, produisant le premier potentiel secondaire (Vb'1) lorsque le transistor de sélection (40a) de la première branche est passants et
- une seconde branche comprenant deux seconds transistors (40b, 42b) montés en série avec la ligne de référence (B2), un premier (40b) de ces transistors, dit transistor de sélection, étant utilisé pour commander la décharge de la ligne de référence et un deuxième (42b) de ces transistors, dit transistor de conversion, produisant le second potentiel secondaire (Vb'2) lorsque le transistor de sélection (40b) de la seconde branche est passant.

**12.** Mémoire selon la revendication 11, caractérisée en ce que pour chaque branche du circuit de conversion courant - tension, le transistor de conversion (40a, 40b) a sa grille de commande reliée au drain du transistor de conversion (40b, 40a) de l'autre branche, de sorte qu'une modification du potentiel apparaissant sur la ligne de bit lors d'un transfert de charges entre la cellule de mémorisation et la ligne de bit induit une modification de la résistivité du transistor (42b) de conversion de la deuxième branche et, par suite, une modification dans un sens contraire de la résistivité du transistor (42a) de conversion de la première branche.

13. Mémoire selon l'une des revendications 10 à 12, caractérisée en ce qu'elle comprend un premier circuit de lecture (44) pour amplifier une différence de potentiel entre les potentiels secondaires, en diminuant la valeur de l'un de ces potentiels.

14. Mémoire selon l'une des revendications 10 à 13, caractérisée en ce qu'elle comprend un deuxième circuit (50) de lecture pour amplifier une différence de potentiel entre les potentiels secondaires, en augmentant la valeur de l'un de ces potentiels.

15. Mémoire selon la revendication 14, la dite mémoire étant alimentée par un potentiel d'alimentation (VCC) et par un potentiel de référence (GND), la valeur initiale du potentiel mémorisé dans la cellule de mémorisation étant sensiblement égale à la valeur du potentiel d'alimentation ou à la valeur du potentiel de référence, et la phase de lecture comprenant une étape de rétablissement de la valeur initiale du potentiel mémorisé lorsque cette valeur initiale est sensiblement égale à la valeur du potentiel d'alimentation,

caractérisée en ce que le rétablissement de la valeur initiale est réalisé par le deuxième circuit de lecture, au travers du transistor de sélection de la première branche du circuit de conversion, et en ce que la mémoire comprend un circuit de complément de précharge (58) pour porter la valeur du potentiel de la ligne de bit (B1) au niveau de la valeur du potentiel d'alimentation et compléter ce rétablissement.

**Patentansprüche**

1. Verfahren zum Lesen eines dynamischen Speichers mit wenigstens einer Bitleitung (B1), einer Wortleitung (W1), einer Speicherzelle (C11), auf die über die Bitleitung und die Wortleitung zugegriffen werden kann, und einer Referenzleitung (B2), wobei die Speicherzelle das Abspeichern eines Anfangspotentials (Vc) ermöglicht, daß eine logische Information wiedergibt, wobei das Verfahren umfaßt:

   - Aufladen der Bitleitung (B1) und der Referenzleitung (B2), um das Potential (Vb1, Vb2) dieser Leitungen auf das Niveau eines Referenzpotentials (Vref) zu bringen, das sich von dem ursprünglich abgespeicherten Potential in der Speicherzelle (C11) unterscheidet,
   - Auswählen der Speicherzelle (C11), um das Potential (Vb1) der Bitleitung (B1) zu modifizieren und so eine Anfangsdifferenz zwischen den Potentialen der Bitleitung und der Referenzleitung (B2) zu erzeugen, und

gekennzeichnet ist durch
Entladen der Bitleitung und der Referenzleitung, wobei über die Leitungen Entladeströme (i1, i2), fließen, und Erzeugen eines Ausgangssignals (OUT1), dessen Zustand die Werte der Entladeströme wiedergibt.

2. Verfahren nach Anspruch 1, dadurch gekennzeichnet, daß die Entladeströme in Abhängigkeit von Werten von Potentialen der Bitleitung und der Referenzleitung gesteuert werden, so daß die Anfangsdifferenz zwischen den Werten dieser Potentiale vergrößert wird.

3. Verfahren nach einem der Ansprüche 1 oder 2, dadurch gekennzeichnet, daß die Entladeströme der Bitleitung und der Referenzleitung in ein erstes und ein zweites Sekundärpotential (Vb'1, Vb'2) konvertiert werden, deren Werte die jeweiligen Werte der Potentiale der Bitleitung und der Referenzleitung wiedergeben, und daß die Sekundärpotentiale verglichen werden, um das Ausgangssignal (OUT1) zu erzeugen.

4. Verfahren nach Anspruch 3, dadurch gekennzeichnet, daß es das Verstärken der Werte des ersten und zweiten Sekundärpotentials umfaßt.

5. Verfahren nach Anspruch 4, dadurch gekennzeichnet, daß die Sekundärpotentiale eine Vergrößerung der Werte der Entladeströme steuern, so daß die Potentialdifferenz zwischen der Bitleitung und der Referenzleitung verstärkt wird.

6. Verfahren nach einem der Ansprüche 4 oder 5, wobei der Speicher durch ein Versorgungspotential (VCC) und ein Referenzpotential (GND) versorgt wird, dadurch gekennzeichnet, daß das Verstärken der Sekundärpotentiale erfolgt, indem eines der Sekundärpotentiale auf das Niveau des Versorgungspotentials und das andere Sekundärpotential auf das Niveau des Referenzpotentials gebracht wird.

7. Verfahren nach Anspruch 6, wobei der Anfangswert des abgespeicherten Potentials in der Speicherzelle im wesentlichen gleich dem Wert des Versorgungspotentials oder dem Wert des Referenzpotentials ist und das Verfahren das Wiederherstellen des Anfangswertes dieses abgespeicherten Potentials umfaßt, wenn der Anfangswert im wesentlichen gleich dem Wert des Versorgungspotentials ist, dadurch gekennzeichnet, daß der Schritt initiiert wird durch das Verstärken des ersten Sekundärpotentials und abgeschlossen wird, indem der Wert des Potentials der Bitleitung auf den Wert des Versorgungspotentials gebracht wird.

**8.** Dynamischer Speicher mit:

- wenigstens einer Bitleitung (B1) und einer Wortleitung (W1),
- wenigstens einer Speicherzelle (C11) zum Abspeichern eines Anfangspotentials (Vc), das eine logische Information wiedergibt, wobei auf die Zelle über die Bitleitung und die Wortleitung zugegriffen werden kann,
- wenigstens einer Referenzleitung (B2), wobei diese Referenzleitung eine zweite Bitleitung sein kann,
- Vorrichtungen (26) zum Aufladen der Bitleitung und der Referenzleitung, so daß ihr Potential in einer Aufladephase auf einen Referenzwert (Vref) gebracht wird, und
- Lesevorrichtungen (44, 50, 141) zum Erzeugen eines Ausgangssignals (OUT1) in einer Lesephase, das das Anfangspotential wiedergibt, das in der Speicherzelle abgespeichert wurde,

dadurch gekennzeichnet, daß
der Speicher Vorrichtungen (40a, 40b, 42a, 42b) für das Entladen der Bitleitung und der Referenzleitung in der Lesephase umfaßt, wobei die Bitleitung und Referenzleitung (B1, B2) von einem ersten und einem zweiten Entladestrom (i1, i2) durchflossen werden und das Ausgangssignal (OUT1) Werte von Entladeströmen wiedergibt.

**9.** Speicher nach Anspruch 8, dadurch gekennzeichnet, daß er Vorrichtungen (42a, 42b) zum Steuern der Werte von Entladeströmen in Abhängigkeit von Werten von Potentialen der Bitleitung und der Referenzleitung umfaßt, um eine Anfangsdifferenz zwischen den Werten der Potentiale zu verstärken.

**10.** Speicher nach einem der Ansprüche 8 oder 9, dadurch gekennzeichnet, daß er einerseits Vorrichtungen (42a, 42b) zum Konvertieren des Entladestroms der Bitleitung in ein erstes Sekundärpotential (Vb'1) und zum Konvertieren des Entladestroms, der durch die Referenzleitung fließt, in ein zweites Sekundärpotential (Vb'2) und andererseits einen Komparator (141) umfaßt, wobei der Komparator die Sekundärpotentiale einliest und das logische Ausgangssignal erzeugt.

**11.** Speicher nach Anspruch 10, dadurch gekennzeichnet, daß er einen Strom/Spannungs-Konverterschaltkreis (38) umfaßt mit:

- einem ersten Zweig, der zwei erste Transistoren (40a, 42a) umfaßt, die in Reihe mit der Bitleitung (B1) geschaltet sind, wobei ein erster (40a) dieser Transistoren, genannt Auswahltransistor, verwendet wird, um das Entladen der Bitleitung zu steuern, und ein zweiter (42a) dieser Transistoren, genannt Konvertertransistor, das erste Sekundärpotential (Vb'1) erzeugt, wenn der Auswahltransistor (40a) des ersten Zweiges leitend ist, und

- einen zweiten Zweig, der zwei Sekundärtransistoren (40b, 42b) umfaßt, die in Reihe mit der Referenzleitung (B2) geschaltet sind, wobei ein erster (40b) dieser Transistoren, genannt Auswahltransistor, verwendet wird zum Steuern des Entladens der Referenzleitung und ein zweiter (42b) dieser Transistoren, genannt Konvertertransistor, das zweite Sekundärpotential (Vb'2) erzeugt, wenn der Auswahltransistor (40b) des zweiten Zweiges leitend ist.

**12.** Speicher nach Anspruch 11, dadurch gekennzeichnet, daß bei jedem Zweig des Strom/Spannungs-Konverterschaltkreises der Konvertertransistor (40a, 40b) über sein Steuergate mit dem Drain des Konvertertransistors (40b, 40a) des anderen Zweiges verbunden ist, so daß eine Änderung des Potentials auf der Bitleitung bei einem Ladungstransfer zwischen der Speicherzelle und der Bitleitung eine Änderung des Widerstandes des Konvertertransistors (42b) des zweiten Zweiges mit sich bringt und daraufhin eine Änderung des Widerstandes des Konvertertransistors (42a) des ersten Zweiges in entgegengesetzter Richtung.

**13.** Speicher nach einem der Ansprüche 10 bis 12, dadurch gekennzeichnet, daß er einen ersten Leseschaltkreis (44) zum Verstärken einer Potentialdifferenz zwischen den Sekundärpotentialen umfaßt, indem der Wert des einen dieser Potentiale erniedrigt wird.

**14.** Speicher nach einem der Ansprüche 10 bis 13, dadurch gekennzeichnet, daß er einen zweiten Schaltkreis (50) zum Lesen für das Verstärken einer Potentialdifferenz zwischen den Sekundärpotentialen umfaßt, indem der Wert des einen dieser Potentiale vergrößert wird.

**15.** Speicher nach Anspruch 14, wobei der Speicher durch ein Versorgungspotential (VCC) und ein Referenzpotential (GND) versorgt wird, wobei der Anfangswert des abgespeicherten Potentials in der Speicherzelle im wesentlichen gleich dem Wert des Versorgungspotentials oder dem Wert des Referenzpotentials ist und die Lesephase als Schritt das Wiederherstellen des Anfangswertes des abgespeicherten Potentials umfaßt, wenn dieser Anfangswert im wesentlichen gleich dem Wert des Versorgungspotentials ist, dadurch gekennzeichnet, daß
das Wiederherstellen des Anfangswertes durch den zweiten Leseschaltkreis über den Auswahltransistor des ersten Zweiges des Konverterschaltkreises realisiert wird und daß der Speicher einen komplementären Schaltkreis für das Aufladen (58) zum Setzen des Wertes des Potentials einer Bitleitung (B1) auf das Niveau des Wertes des Versorgungspotentials und zum Abschließen dieses Wiederherstellens umfaßt.

## Claims

1. Method of reading a dynamic memory comprising at least one bit line (B1), one word line (W1), one storage cell (C11) accessible by means of the bit line and word line, and one reference line (B2), the storage cell making it possible to store an initial potential (Vc) representing logic information, the said method comprising:

   - a step of precharging the bit line (B1) and the reference line (B2) in order to raise the potential (Vb1, Vb2) of these lines to the level of a reference potential (Vref) different from the initial potential stored in the storage cell (C11),

   - a step of selecting the storage cell (C11) in order to produce a modification of the potential (Vb1) of the bit line (B1) and thus create an initial difference between the potentials of the bit line and of the reference line (B2), and

   characterised in that it comprises a step of discharging the bit line and the reference line, the said lines then having discharge currents (i1, i2) pass through them, and a step of producing an output signal (OUT1) whose state represents the values of the discharge currents.

2. Method according to Claim 1, characterised in that the discharge current values are controlled according to the values of the potentials of the bit line and reference line, in a direction tending to increase the initial difference between the values of the said potentials.

3. Method according to one of Claims 1 or 2, characterised in that the discharge currents of the bit line and reference line are converted into first and second secondary potentials (Vb'1, Vb'2) whose values represent the respective values of the potentials of the bit line and reference line, and in that the secondary potentials are compared in order to produce the output signal (OUT1).

4. Method according to Claim 3, characterised in that it comprises a step of amplifying the values of the first and second secondary potentials.

5. Method according to Claim 4, characterised in that the secondary potentials control an increase in the values of the discharge currents, so as to amplify the potential difference between the bit line and reference line.

6. Method according to one of Claims 4 or 5, the said memory being supplied by a supply potential (VCC) and by a reference potential (GND), characterised in that the secondary potentials are amplified by bringing one of the secondary potentials to the level of the supply potential and the other secondary potential to the level of the reference potential.

7. Method according to Claim 6, the initial value of the potential stored in the storage cell being substantially equal to the value of the supply potential or to the value of the reference potential, and the method comprising a step of reestablishing the initial value of this stored potential when this initial value is substantially equal to the value of the supply potential, characterised in that the said step is initiated by the amplification of the first secondary potential and is completed by raising the value of the potential of the bit line to the value of the supply potential.

8. Dynamic memory comprising

   - at least one bit line (B1) and one word line (W1),

   - at least one storage cell (C11) for storing an initial potential (Vc) representing logic information, the said cell being accessible by means of the bit line and the word line,

   - at least one reference line (B2), this reference line being able to be a second bit line,

   - means (26) for precharging the bit line and reference line so as to bring their potential to a reference value (Vref) during a precharging phase, and

   - reading means (44, 50, 141) for producing, during a read phase, an output signal (OUT1) representing the initial potential stored in the storage cell,

   characterised in that the memory comprises means (40a, 40b) for discharging the bit and reference lines, during the read phase, the said bit and reference lines (B1, B2) then having first and second discharge currents (i1, i2) pass through them and the output signal (OUT1) representing the values of the discharge currents.

9. Memory according to Claim 8, characterised in that it comprises means (42a, 42b) for controlling the values of the discharge currents as a function of the values of the potentials of the bit line and reference line in a direction tending to increase an initial difference between the values of the said potentials.

10. Memory according to one of Claims 8 or 9, characterised in that it comprises on the one hand means (42a, 42b) for converting the discharge current of the bit line into a first secondary potential (Vb'1) and for converting the discharge current passing through the reference line into a second secondary potential (Vb'2) and on the other hand a comparator (141), the said comparator receiving the secondary potentials and producing the logic output signal.

11. Memory according to Claim 10, characterised in that it comprises a current to voltage conversion circuit (38) comprising:

    - a first arm comprising two first transistors (40a, 42a) connected in series with the bit line (B1), a first (40a) of these transistors, referred to as the selection transistor, being used for controlling the discharge of the bit line, and a second (42a) of these transistors, referred to as the conversion transistor, producing the first secondary potential (Vb'1) when the selection transistor (40a) of the first arm is conductive, and

    - a second arm comprising two second transistors (40b, 42b) connected in series with a reference line (B2), a first (40b) of these transistors, referred to as the selection transistor, being used for controlling the discharge of the reference line and a second (42b) of these transistors, referred to as the conversion transistor, producing the second secondary potential (Vb'2) when the selection transistor (40b) of the second arm is conductive.

12. Memory according to Claim 11, characterised in that, for each arm of the current to voltage conversion circuit, the conversion transistor (40a, 40b) has its control gate connected to the drain of the conversion transistor (40b, 40a) of the other arm, so that a modification of the potential appearing on the bit line when there is a transfer of charges between the storage cell and the bit line causes a modification of the resistivity of the conversion transistor (42b) of the second arm and consequently a modification, in an opposite direction, of the resistivity of the conversion transistor (42a) of the first arm.

13. Memory according to one of Claims 10 to 12, characterised in that it comprises a first read circuit (44) for amplifying a potential difference between the secondary potentials, by reducing the value of one of these potentials.

14. Memory according to one of Claims 10 to 13, characterised in that it comprises a second read circuit (50) for amplifying a potential difference between the secondary potentials, by increasing the value of one of these potentials.

15. Memory according to Claim 14, the said memory being supplied by a supply potential (VCC) and by a reference potential (GND), the initial value of the potential stored in the storage cell being substantially equal to the value of the supply potential or to the value of the reference potential, and the read phase comprising a step of reestablishing the initial value of the stored potential when this initial value is substantially equal to the value of the supply potential,
characterised in that the initial value is reestablished by the second read circuit, through the selection transistor of the first arm of the conversion circuit, and in that the memory comprises an additional precharging circuit (58) for raising the value of the potential of the bit line (B1) to the level of the value of the supply potential and for completing this reestablishment.

FIG. 1

FIG. 2

FIG. 3

FIG. 4a    PRECS

FIG. 4b    SEL1

FIG. 4c    WL1

FIG. 4d    SEL2

FIG. 4e    NSEL2

FIG. 4f    SEL3

FIG. 4g

VCC

Vbl2
Vbl'2

Vbl'2

Vbl2

Vref

Vbl'1

Vbl1

GND

Vbl'1, Vbl1